**Europäisches Patentamt**

**European Patent Office**

**Office européen des brevets**

(19)

(11) Veröffentlichungsnummer: **0 300 440 B1**

(12) **EUROPÄISCHE PATENTSCHRIFT**

(45) Veröffentlichungstag der Patentschrift: **30.03.94**

(21) Anmeldenummer: **88111649.5**

(22) Anmeldetag: **20.07.88**

(51) Int. Cl.⁵: **G06F 1/00**

(54) **Rücksetzschaltung für Mikroprozessoren und Zähler.**

(30) Priorität: **17.09.87 DE 3731207**
**22.07.87 DE 3724241**

(43) Veröffentlichungstag der Anmeldung:
**25.01.89 Patentblatt 89/04**

(45) Bekanntmachung des Hinweises auf die
Patenterteilung:
**30.03.94 Patentblatt 94/13**

(84) Benannte Vertragsstaaten:
**DE FR GB NL**

(56) Entgegenhaltungen:
**EP-A- 0 148 364**
**DE-A- 3 336 534**

**PATENT ABSTRACTS OF JAPAN, BAND 10,
NR. 275 (E-438) (2331) 18. SEPTEMBER 1986
& JP-A-61-95 612**

**PATENT ABSTRACTS OF JAPAN, BAND 10,
NR. 54 (E-385) (2111) 4. MÄRZ 1986 & JP-
A-60-206 218**

**PATENT ABSTRACTS OF JAPAN, BAND 9,
NR. 131 (E-319) (1854), 6. JUNI 1985 & JP-
A-60-18 017**

(73) Patentinhaber: **HONEYWELL AG**
**Kaiserleistrasse 39**
**D-63067 Offenbach(DE)**

(72) Erfinder: **Riewe, Franz-Jürgen**
**Talstrasse 25**
**D-6458 Rodenbach(DE)**

(74) Vertreter: **Herzbach, Dieter, Dipl.-Ing. et al**
**Honeywell Holding AG**
**Patent- und Lizenzabteilung**
**Kaiserleistrasse 39**
**Postfach 10 08 65**
**D-63008 Offenbach (DE)**

EP 0 300 440 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung bezieht sich auf eine Rücksetzschaltung für Mikroprozessoren und Zähler nach dem Gattungsbegriff des Patentanspruches 1.

Mikroprozessoren benötigen beim Einschalten ihrer Versorgungsspannung eine automatische Rückstellung, so daß über den Rücksetzvektor die Startadresse gefunden und der Mikroprozessor funktionsfähig wird, bevor irgendwelche anliegenden Eingangssignale fehlerhaft verarbeitet werden. In diesem Zusammenhang ist es aus der DE-AS 29 36 683 bekannt, ein einfaches RC-Integrationsglied zu verwenden, das das Rücksetzsignal aus der Versorgungsspannung ableitet.

Solche RC-Glieder sind jedoch für die Herleitung eines Rücksetzsignales nur geeignet, wenn der Mikroprozessor unmittelbar an eine Versorgungsspannung angelegt wird, so daß die Spannungsversorgung des Mikroprozessors entsprechend steil ansteigt. Wird die Versorgungsspannung des Mikroprozessors beispielsweise aus einer höheren Batteriespannung abgeleitet und wird der Einschaltstrom aus Systemgründen begrenzt, dann muß das RC-Glied für die Rücksetzung sehr groß bemessen werden. Dies bedingt, daß die Rücksetzung sehr lange dauert und das System sehr spät seinen Betrieb aufnimmt.

Eine gattungsgemäße Rücksetzschaltung, die die zuvor erwähnten Nachteile nicht aufweist, ist aus Patent Abstracts of Japan, Band 10, Nr. 275 (E-438) (2331), 18.9.1986 und JP-A-61 95 612 bekannt. Dort wird aus einer Spannungsquelle eine Versorgungsspannung über ein RC-Versorgungsglied gebildet. Ferner ist ein RC-Rücksetzglied der Versorgungsspannung parallelgeschaltet. Die Zeitkonstante des Rücksetzgliedes ist groß im Vergleich zu der Zeitkonstante des Versorgungsgliedes. Um die Zeit der Rücksetzung zu verkürzen, ist dem Widerstand des RC-Rücksetzgliedes ein niederohmiger Bypasszweig parallelgeschaltet, der aktiviert wird, wenn die Versorgungsspannung einen vorgegebenen Wert erreicht hat.

Die bekannte Schaltung verwendet eine Reihe von Komparatoren, Verstärkern und Transistoren, wobei insbesondere die Komparatoren eine eigene Stromversorgung aufweisen müssen. Ferner sind an die Spannungsquelle zwei Spannungsteiler angeschlossen, über die ständig ein Strom fließt, um jeweils einen Eingang der Komparatoren zu beaufschlagen.

Es ist daher die Aufgabe der vorliegenden Erfindung, die bekannte Schaltungsanordnung hinsichtlich Aufwand, Zuverlässigkeit und Stromverbrauch zu verbessern. Die Lösung dieser Aufgabe gelingt gemäß den Merkmalen des Patentanspruches 1. Weitere vorteilhafte Ausgestaltungen der erfindungsgemäßen Rücksetzschaltung sind den abhängigen Ansprüchen entnehmbar.

Anhand von in den Figuren der beiliegenden Zeichnung dargestellten Ausführungsbeispielen sei im folgenden die erfindungsgemäße Rücksetzschaltung näher erläutert. Es zeigen:

Fig. 1 eine erste Schaltung gemäß der Erfindung zur Beendigung der Rücksetzung des Mikroprozessors unmittelbar nach Erreichen seiner Betriebsspannung für die Funktion $\overline{Reset}$;

Fig. 1a ein Diagramm zur Erläuterung der Funktionsweise der Schaltung gemäß Figur 1;

Fig. 2 eine zweite Schaltung gemäß der Erfindung zur Beendigung der Rücksetzung des Mikroprozessors unmittelbar nach Erreichen seiner Betriebsspannung für die Funktion Reset.

Fig. 3 eine Modifikation der Schaltung gemäß Fig. 1; und

Fig. 3a ein Diagramm zur Erläuterung der Funktionsweise der Schaltung gemäß Fig. 3.

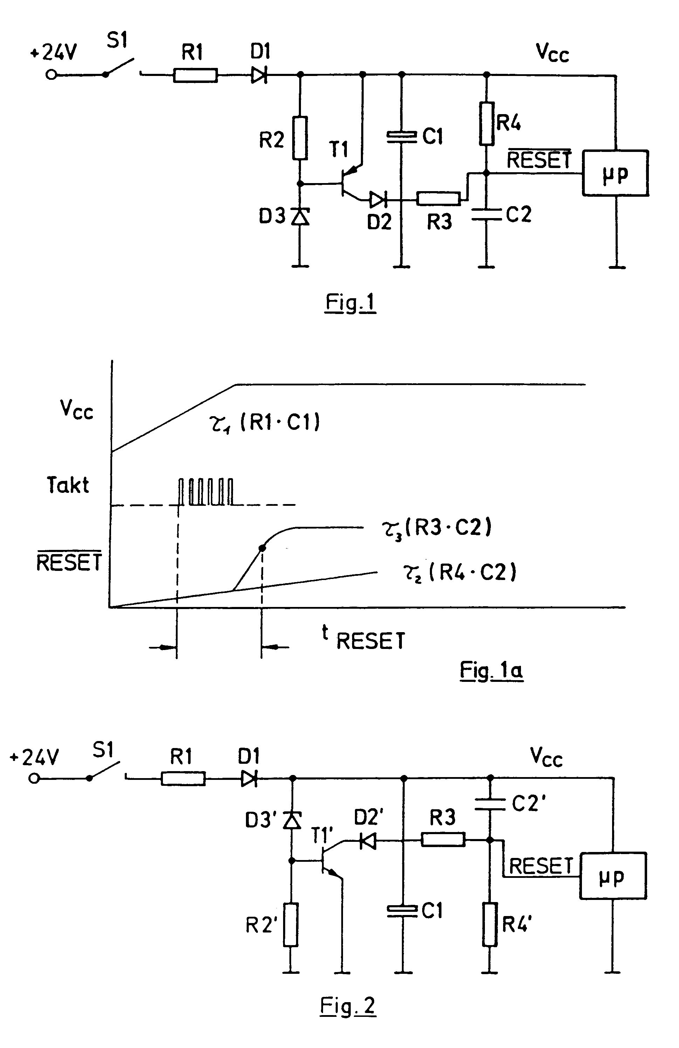

Gemäß Figur 1 wird die Betriebsspannung $V_{cc}$ für einen Mikroprozessor $\mu$p aus einer Spannung von +24V abgeleitet. Zu diesem Zweck wird nach Schließen eines Schalters S1 ein Elektrolytkondensator C1 über die Reihenschaltung bestehend aus einem Widerstand R1 und einer Diode D1 aufgeladen. Der Widerstand R1 und der Elektrolytkondensator C1 bilden ein RC-Versorgungsglied mit einer ersten Zeitkonstanten $\tau_1$. Dem Elektrolytkondensator C1 ist die Reihenschaltung bestehend aus einem Widerstand R4 und einem Kondensator C2 parallelgeschaltet. Der Spannungsteilerabgriff dieser Reihenschaltung ist auf den Setz-Eingang ($\overline{RESET}$) des Mikroprozessors $\mu$p geschaltet. Der Widerstand R4 wird mit dem Kondensator C2 als Integrierglied betrieben und das auf diese Weise gebildete RC-Rücksetzglied weist eine entsprechende zweite Zeitkonstante $\tau_2$ auf. Diese zweite Zeitkonstante $\tau_2$ ist sehr groß in bezug auf die erste Zeitkonstante $\tau_1$.

Die Emitter-Kollektor-Strecke eines pnp-Transistors T1 ist zusammen mit einer Diode D2 und einem Widerstand R3 in Reihe geschaltet, wobei diese Reihenschaltung zwischen der sich aufbauenden Betriebsspannung $V_{cc}$ des Mikroprozessors $\mu$p und dem Abgriffpunkt des RC-Rücksetzgliedes angeordnet ist. Die Basis des Transistors T1 ist an einen Spannungsteiler angeschlossen, der aus der Reihenschaltung eines Widerstandes R2 und einer Zenerdiode D3 besteht, wobei diese Reihenschaltung dem Elektrolytkondensator C1 parallelgeschaltet ist. Der Widerstand R3 bildet zusammen mit dem Kondensator C2 ein RC-Glied mit einer dritten Zeitkonstanten $\tau_3$, die im Vergleich zu der ersten

Zeitkonstanten $\tau_1$ und erst recht im Vergleich zu der zweiten Zeitkonstanten $\tau_2$ sehr klein bemessen ist.

Aus diesem Schaltungsaufbau ergibt sich die nachfolgend geschilderte Funktion der Schaltungsanordnung, was unter Zuhilfenahme von Figur 1a erläutert werden soll. Nach Betätigung des Schalters S1 steigt die aus der Versorgungsspannung von +24V abgeleitete Betriebsspannung $V_{cc}$ des Mikroprozessors $\mu$p an, indem sich der Kondensator C1 über den Widerstand R1 und die Diode D1 auflädt. Der Anstieg der Betriebsspannung $V_{cc}$ ist im wesentlichen durch die Zeitkonstante $\tau_1$ dieses RC-Versorgungsgliedes R1, C1 vorgegeben. Beim Erreichen einer bestimmten Größe der Betriebsspannung $V_{cc}$ schwingt der Taktoszillator des Mikroprozessors $\mu$p an, wie dies in Figur 1a veranschaulicht ist.

In der Zeit, wo der Kondensator C1 aufgeladen wird, liegt durch C2 zunächst Reset an. Es folgt dann eine Aufladung des Kondensators C2 über den Widerstand R4. Die Zeitkonstante $\tau_2$ dieses RC-Rücksetzgliedes R4, C2 ist jedoch sehr groß in bezug auf die Zeitkonstante des RC-Versorgungsgliedes R1, C1, so daß die Rückstellung des Mikroprozessors auf Grund dieser Schaltungsanordnung alleine sehr lange dauern würde. Um dies zu verhindern, ist der pnp-Transistor T1 mit seinem Emitter an die sich aufbauende Betriebsspannung $V_{cc}$ einerseits und mit seiner Basis an den Spannungsteiler R2, D3 angeschlossen. Beim Erreichen des maximalen Wertes von $V_{cc}$, der durch die Basis/Emitterspannung des Transistors T1 und die Zenerspannung der Zenerdiode D3 vorgegeben ist, wird der Transistor T1 leitend. In dem Augenblick, wo der Transistor T1 leitend wird, schaltet er die Betriebsspannung $V_{cc}$ über die Diode D2 und den niederohmigen Widerstand R3 auf den Kondensator C2, so daß infolge der sehr geringen Zeitkonstanten $\tau_3$ (R3, C2) der Kondensator C2 sehr rasch aufgeladen wird und die Rückstellung des Mikroprozessors aufgehoben wird, wie dies aus Figur 1a ersichtlich ist.

Die in Figur 2 dargestellte Schaltungsanordnung dient der Lösung des gleichen Problems für Schaltungen mit Reset. Soweit die gleichen Komponenten verwendet werden, sind diese mit gleichen Bezugzeichen versehen und der verwendete Beistrich dient der Bezeichnung von Komponenten, die an einem vertauschten Ort angeordnet sind, einen anderen Leitfähigkeitstyp aufweisen oder mit anderer Polarität verwendet werden. So wird nunmehr ein Differenziglied C2′, R4′ verwendet, um anfänglich für den Mikroprozessor $\mu$p ein Rückstellsignal (RESET) zu erzeugen. In dem Spannungsteiler D3′, D2′ haben die Komponenten eine Vertauschung erfahren und der Transistor T1′ ist nunmehr vom npn-Leitfähigkeitstyp, wobei seine Basis wiederum an den Spannungsteilerabgriff angeschlossen ist, sein Emitter jedoch an Bezugspotential liegt. Die Polarität der Diode D2′ ist nunmehr umgekehrt.

Aus dieser Schaltungsanordnung resultiert folgende Funktion: Beim Schließen des Schalters S1 wird wiederum der Elektrolytkondensator C1 über den Widerstand R1 und die Diode D1 aufgeladen. Zugleich springt das Potential an dem Abgriffpunkt des RC-Rücksetzgliedes C2′, R4′ auf einen relativ hohen Wert, so daß ein Rückstellsignal für den Mikroprozessor vorliegt. Erst wenn die Betriebsspannung $V_{cc}$ des Mikroprozessors $\mu$p einen durch die Basis/Emitterspannung des Transistors T1′ und die Zenerspannung der Zenerdiode D3′ bestimmten Wert erreicht hat, wird der Transistor T1′ durchgeschaltet und der Rückstelleingang des Mikroprozessors über den niederohmigen Widerstand R3 praktisch an Bezugspotential gelegt, so daß die Rückstellung aufgehoben wird.

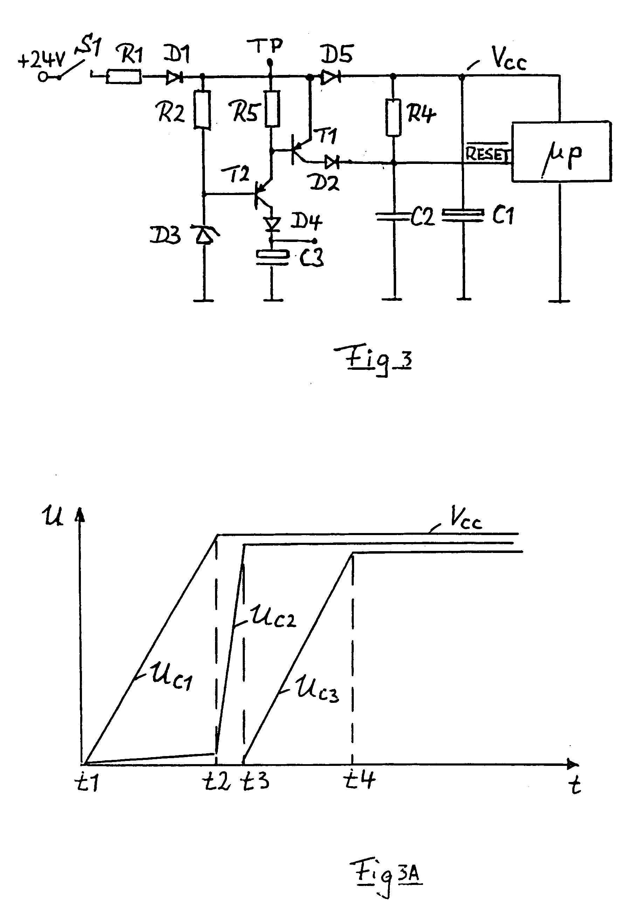

Gemäß Fig. 3 ist die Emitter-Kollektor-Strecke des pnp-Transistors T1 mit der Diode D2 in Reihe geschaltet, wobei diese Reihenschaltung zwischen der sich aufbauenden Betriebsspannung $V_{cc}$ des Mikroprozessors $\mu$p und dem Abgriffpunkt des RC-Rücksetzgliedes angeordnet ist. Eine Diode D5 entkoppelt diese Reihenschaltung aus dem Transistor T1 und der Diode D2 sowie davorliegende Querzweige von der Betriebsspannung $V_{cc}$ des Mikroprozessors $\mu$p. Der gemeinsame Schaltungspunkt zwischen den beiden Dioden D1 und D5 ist mit TP bezeichnet.

Die Basis des Transistors T1 ist an einen Spannungsteiler angeschlossen, der aus der Reihenschaltung eines Widerstandes R5, der Basis-Kollektor-Strecke eines weiteren pnp-Transistors T2, einer Diode D4 und eines Zündkondensators C3 besteht. Die Basis des Transistors T1 ist hierbei an den gemeinsamen Schaltungspunkt des Widerstandes R5 und des Emitters des weiteren Transistors T2 gelegt.

Die Basis des weiteren Transistors T2 ist an einen Spannungsteiler gelegt, der aus der Reihenschaltung des Widerstandes R2 und der Zenerdiode D3 besteht, wobei diese Reihenschaltung dem Elektrolytkondensator C1 parallelgeschaltet ist und durch die Diode D5 eine Entkopplung vorgegeben ist.

Aus diesem Schaltungsaufbau ergibt sich die nachfolgend geschilderte Funktion der Schaltungsanordnung, was unter Zuhilfenahme von Figur 3a erläutert werden soll. Nach Betätigung des Schalters S1 steigt die aus der Versorgungsspannung von +24V abgeleitete Betriebsspannung $V_{cc}$ des Mikroprozessors $\mu$p an, indem sich der Elektrolytkondensator C1 über den Widerstand R1 und die Dioden D1, D5 auflädt. Der Anstieg der Betriebsspannung $V_{cc}$ ist im wesentlichen durch die Zeit-

konstante $\tau 1$ dieses RC-Versorgungsgliedes R1, C1 vorgegeben. Beim Erreichen einer bestimmten Größe der Betriebsspannung $V_{cc}$ schwingt der Taktoszillator des Mikroprozessors $\mu$p an.

In der Zeit, wo der Elektrolytkondensator C1 aufgeladen wird, liegt durch den Kondensator C2 zunächst das Signal RESET mit niedrigem Pegel an dem Mikroprozessor $\mu$p an. Es erfolgt zwar eine Aufladung des Kondensators C2 über den Widerstand R4; die Zeitkonstante $\tau 2$ dieses RC-Rücksetzgliedes R4, C2 ist jedoch sehr groß in bezug auf die Zeitkonstante des RC-Versorgungsgliedes R1, C1, so daß die Rückstellung des Mikroprozessors aufgrund dieser Schaltungsanordnung alleine sehr lange dauern würde. Um dies zu verhindern, ist der den Transistor T1 aufweisende Bypasszweig vorgesehen. Erreicht die Spannung im Schaltungspunkt TP den Wert

$$U_{Z(D3)} + U_{BE(T2)} + U_{BE(T1)},$$

so tritt eine Begrenzung der Versorgungsspannung $V_{cc}$ auf folgenden Wert ein:

$$U_{Z(D3)} + U_{BE(T2)} + U_{BE(T1)} - U_{(D5)}.$$

Der Strom, der für die Aufladung des Elektrolytkondensators C1 nicht mehr benötigt wird, fließt nun über den Transistor T1 und die Diode D2 in den Kondensator C2. Der von dem weiteren Transistor T2 gezogene Strom ist durch folgenden Wert vorgegeben:

$$\frac{I_{E(T1)}}{B} + \frac{U_{BE(T1)}}{R5},$$

wobei B = Gleichstromverstärkungsfaktor
Dieser in den Emitter des weiteren Transistors T2 fließende Strom teilt sich wiederum auf in den über die Diode D4 in den Zündkondensator C3 fließenden Strom und den Basisstrom des weiteren Transistors T2, der durch folgenden Wert vorgegeben ist:

$$\frac{I_{E(T2)}}{B}$$

Da der Basisstrom des weiteren Transistors T2 sehr klein ist, muß der Mindeststrom zur Erzeugung der Zenerspannung der Zenerdiode D3 über den Widerstand R2 geliefert werden, der sich folgendermaßen darstellt:

$$I_{Z(D3)} = \frac{U_{BE(T1)} + U_{BE(T2)}}{R2}$$

Nach Aufladung des Rücksetzkondensators C2 wird der Kollektorstrom des Transistors T1 zu Null. Der überschießende Strom aus der Basis des Transistors T1 fließt in den Emitter des weiteren Transistors T2 und teilt sich in der beschriebenen Weise auf.
Ist die Aufladung des Zündkondensators C3 beendet, so wird der Kollektorstrom des weiteren Transistors T2 zu Null, und der gesamte Strom fließt, soweit er nicht benötigt wird, aus der Basis des Transistors T2 in die Zenerdiode D3.

Aus Figur 3a ist erkennbar, daß beim Schließen des Schalters S1 im Zeitpunkt t1 die Aufladung des Elektrolytkondensators C1 beginnt und vorgegeben durch die Zeitkonstante $\tau 1$ und die Spannungsbegrenzung durch $U_{Z(D3)} + U_{BE(T1)} + U_{BE(T1)} - U_{(D5)}$ im Zeitpunkt t2 abgeschlossen ist. Danach steht die Versorgungsspannung $V_{cc}$ zur Verfügung. Gleichzeitig wird im Zeitpunkt t2 die den Transistor T1 aufweisende Stromkaskade aktiviert, so daß ausgehend von einer geringfügigen Aufladung des Kondensators C2 dieser sehr schnell auf einen Wert aufgeladen wird, durch den die Rückstellung des Mikroprozessors beendet wird. Diese Aufladung ist im Zeitpunkt t3 vorgegeben, und die Zeitspanne zwischen t2 und t3 ist bestimmt durch den Kollektorstrom von Transistor T1 und die Kapazität von Kondensator C2. Anschließend an den Zeitpunkt t3 erfolgt die Aufladung des Zündkondensators C3 über den Transistor T2 und die Diode D4. Die Transistoren T1, T2 arbeiten in einer Kaskade und wirken als Konstantstromquellen.

## Patentansprüche

1. Rücksetzschaltung für Mikroprozessoren und Zähler, wobei die Versorgungsspannung aus einer Batteriespannung über ein strombegrenzendes RC-Versorgungsglied (R1, C1) abgeleitet wird, mit einem RC-Rücksetzglied (R4, C2) parallel zu der sich aufbauenden Versorgungsspannung ($V_{cc}$) und mit einer Zeitkonstanten ($\tau_2$), die groß im Vergleich zu der Zeitkonstante ($\tau_1$) des RC-Versorgungsgliedes ist, wobei ein Abgriff des RC-Rücksetzgliedes an den Rücksetzeingang des Mikroprozessors oder Zählers angeschlossen ist, mit einem von der sich aufbauenden Versorgungsspannung ($V_{cc}$) gesteuerten, niederohmigen Bypasszweig (T1, D2, R3) parallel zum Widerstand (R4) des RC-Rücksetzgliedes (R4, C2) zur Aufhebung der Rücksetzung nach dem Erreichen einer vorgebbaren Versorgungsspannung,

wobei der Bypasszweig die Reihenschaltung eines Schalttransistors (T1) und einer Diode (D2) aufweist, **dadurch gekennzeichnet, daß** die Basis des Schalttransistors (T1) an einen Spannungteiler aus einem Widerstand (R2) und einer Zenerdiode (D3) angeschlossen ist, der dem Kondensator (C1) des RC-Versorgungsgliedes parallelgeschaltet ist.

2.  Rücksetzschaltung nach Anpruch 1, **dadurch gekennzeichnet, daß** ein niederohmiger Widerstand (R3) in dem Bypasszweig angeordnet ist, der mit dem Kondensator (C2) des RC-Rücksetzgliedes ein RC-Glied bildet, dessen Zeitkonstante ($\tau_3$) klein im Vergleich zu der Zeitkonstante ($\tau_1$) des RC-Versorgungsgliedes (R1,C1) ist.

3.  Rücksetzschaltung nach Anspruch 1, **dadurch gekennzeichnet, daß** das RC-Rücksetzglied durch ein Integrierglied (R4, C2) vorgegeben ist, dessen Abgriff an den Setzeingang ($\overline{\text{RESET}}$) des Mikroprozessors ($\mu$p) oder Zählers angeschlossen ist.

4.  Rücksetzschaltung nach Anspruch 1, **dadurch gekennzeichnet, daß** das RC-Rücksetzglied durch ein Differenzierglied (C2', R4') vorgegeben ist, dessen Abgriff an den Rücksetzeingang (RESET) des Mikroprozessors ($\mu$p) oder Zählers angeschlossen ist und daß der Bypasszweig (T1', D2', R3) der zusätzlichen Entladung des Kondensators (C2') des RC-Rücksetzgliedes (R4, C2) dient.

5.  Rücksetzschaltung nach Anspruch 1, **dadurch gekennzeichnet, daß** ein weiterer Transistor (T2) angeordnet ist, dessen Emitter an die Basis des ersten Transistors (T1) und über einen Widerstand (R5) an die Versorgungsspannung ($V_{cc}$) angeschlossen ist, dessen Kollektor über eine weitere Diode (D4) an einen Zündkondensator (C3) angeschlossen ist und dessen Basis an einen Spannungteiler (R2, D3) angeschlossen ist, der dem Kondensator (C1) des RC-Versorgungsgliedes parallelgeschaltet ist.

6.  Rücksetzschaltung nach Anspruch 5, **dadurch gekennzeichnet, daß** zwischen dem Spannungteiler (R2, D3) und dem Kondensator (C1) des RC-Versorgungsgliedes eine Entkopplungsdiode (D5) angeordnet ist.

## Claims

1.  Reset circuit for microprocessors and counters, whereat the supply voltage is derived from a battery voltage via a current-limiting RC-supply means (R1,C1), comprising a RC-reset means (R4,C2) in parallel to the arising supply voltage (Vcc) and having a time constant ($\tau 2$) which is large in comparison with the time constant ($\tau 1$) of the RC-supply means, whereat a tap from the RC-reset means is connected with the reset input of the microprocessor or counter, further comprising a low-resistance bypass branch (T1,D2,R3) connected in parallel to the resistor (R4) of the RC-reset means (R4,C2) and controlled by the arising supply voltage (Vcc) in order to cancel the reset condition after attaining a predetermined supply voltage, whereat the bypass branch comprises the series connection of a switching transistor (T1) and a diode (D1), **characterized in that** the base of the switching transistor (T1) is connected to a voltage divider, comprising a resistor (R2) and a Zener diode (D3) with said voltage divider being connected in parallel to the capacitor (C1) of the RC-supply means.

2.  Reset circuit according to claim 1, **characterized in that** a low impedance resistor (R3) is arranged within the bypass branch which together with the capacitor (C2) of the RC-reset means forms a RC-means the time constant ($\tau 3$) of which is small in comparison with the time constant ($\tau 1$) of the RC-supply means (R1,C1).

3.  Reset circuit according to claim 1, **characterized in that** the RC-reset means is provided by an integrating means (R4,C2) the tap of which is connected to the set input (RESET) of the microprocessor ($\mu$p) or the counter, respectively.

4.  Reset circuit according to claim 1, **characterized in that** the RC-reset means is provided by a derivative means (C2',R4') the tap of which is connected to the reset input (RESET) of the microprocessor ($\mu$p) or the counter, respectively and that the bypass branch (T1',D2',R3) serves to additionally discharge the capacitor (C2') of the RC-reset means (R4,C2).

5.  Reset circuit according to claim 1, **characterized in that** a further transistor (T2) is arranged the emitter of which at one hand is connected to the base of the first transistor (T1) and at the other hand is connected to the supply voltage (Vcc) via a resistor (R5) with the collector of said further transistor being connected via a further diode (D4) to an ignition capacitor (C3) and with the base of said further transistor being connected to a voltage divider (R2,D3) which is connected in parallel to the capacitor (C1) of the RC-supply means.

6. Reset circuit according to claim 5, **characterized in that** in between the voltage divider (R2,D3) and the capacitor (C1) of the RC-supply means a decoupling diode (D5) is arranged.

## Revendications

1. Circuit de remise à zéro pour microprocesseurs et compteurs, la tension d'alimentation étant dérivée d'une tension de batterie par l'intermédiaire d'un circuit RC d'alimentation limiteur de courant (R1, C1), comportant un circuit RC de remise à zéro (R4, C2) en parallèle à la tension d'alimentation (Vcc) qui s'établit, et présentant une constante de temps ($\tau2$) qui est grande par rapport à la constante de temps ($\tau1$) du circuit RC d'alimentation, un piquage du circuit RC de remise à zéro étant raccordé à l'entrée de remise à zéro du microprocesseur ou du compteur, l'ensemble comportant également une branche en dérivation (T1, D2, R3) de faible impédance, commandée par la tension d'alimentation (Vcc) qui s'établit, et disposée en parallèle à la résistance (R4) du circuit RC de remise à zéro (R4, C2), pour supprimer la remise à zéro après avoir atteint une tension d'alimentation pouvant être prédéfinie, la branche en dérivation présentant un circuit série composé d'un transistor de commutation (T1) et d'une diode (D2), caractérisé en ce que la base du transistor de commutation (T1) est raccordée à un diviseur de tension qui est composé d'une résistance (R2) et d'une diode Zener (D3), et qui est monté en parallèle au condensateur (C1) du circuit RC d'alimentation.

2. Circuit de remise à zéro selon la revendication 1, caractérisé en ce que dans la branche en dérivation est disposée une résistance (R3) de faible valeur ohmique, qui forme avec le condensateur (C2) du circuit RC de remise à zéro, un circuit RC dont la constante de temps ($\tau3$) est petite par rapport à la constante de temps ($\tau1$) du circuit RC d'alimentation (R1, C1).

3. Circuit de remise à zéro selon la revendication 1, caractérisé en ce que le circuit RC de remise à zéro est défini par un circuit intégrateur (R4, C2) dont le piquage est raccordé à l'entrée de mise à un ($\overline{RESET}$) du microprocesseur ($\mu$p) ou du compteur.

4. Circuit de remise à zéro selon la revendication 1, caractérisé en ce que le circuit RC de remise à zéro est défini par un circuit différentiateur (C2', R4'), dont le piquage est raccordé à l'entrée de remise à zéro (RESET) du microprocesseur ($\mu$p) ou du compteur, et en ce que la branche en dérivation (T1', D2', R3) sert à la décharge supplémentaire du condensateur (C2') du circuit RC de remise à zéro (R4', C2').

5. Circuit de remise à zéro selon la revendication 1, caractérisé en ce que l'on met en place un autre transistor (T2), dont l'émetteur est raccordé à la base du premier transistor (T1) et, par l'intermédiaire d'une résistance (R5), à la tension d'alimentation (Vcc), dont le collecteur est raccordé à un condensateur d'amorçage (C3) par l'intermédiaire d'une autre diode (D4), et dont la base est raccordée à un diviseur de tension (R2, D3) qui est monté en parallèle au condensateur (C1) du circuit RC d'alimentation.

6. Circuit de remise à zéro selon la revendication 5, caractérisé en ce qu'entre le diviseur de tension (R2, D3) et le condensateur (C1) du circuit RC d'alimentation, est disposée une diode de découplage (D5).

Fig.1

Fig. 1a

Fig. 2

Fig 3

Fig 3A